# EUROPÄISCHE PATENTANMELDUNG

(11) **EP 2 533 306 A2**
(43) Veröffentlichungstag der Anmeldung: **12.12.2012**
(21) Anmeldenummer: 12405051.9
(22) Anmeldetag: 04.06.2012
(51) Int. Cl.: H01L 31/18, H01L 31/073

(54) **Verfahren zur Herstellung von Dünnschichtsolarzellen mit gesinterten Halbleiterschichten sowie nach diesem Verfahren hergestellte Dünnschichtsolarzellen**

(30) Priorität: 07.06.2011 CH 9582011
(71) Anmelder: Von Roll Solar AG, 8274 Tägerwilen (CH)
(72) Erfinder: Gerber, Sandro, 8580 Amriswil (CH)
(74) Vertreter: Gachnang, Hans Rudolf

(57) **Zusammenfassung**

Bei der Herstellung einer Dünnschichtsolarzelle mit einer gesinterten ersten Halbleiterschicht wird der Anteil von Fremdphasen an der Oberfläche dieser ersten Halbleiterschicht minimiert, indem die Sinterung in einer Schutzgasatmosphäre unter Ausschluss von Sauerstoff erfolgt, und/oder indem nach dem Sintern der ersten Halbleiterschicht unerwünschte Oxide in einem Reinigungsschritt von der Oberfläche dieser Halbleiterschicht herausgelöst werden.

## Beschreibung

Gegenstand der Erfindung ist ein Verfahren zur Herstellung von Dünnschichtsolarzellen sowie eine nach diesem Verfahren hergestellte Dünnschichtsolarzelle gemäss Oberbegriff der Patentansprüche 1 und 10.

Bei der Herstellung von Dünnschichtsolarzellen werden auf einem Substrat oder alternativ auf einem transparenten Superstrat wie z.B. Glas sequentiell mehrere dünne Schichten unterschiedlicher Materialien aufgebracht. In der Regel sind zwei dieser Schichten aus unterschiedlichen halbleitenden Materialien gefertigt, von denen eine als Absorberschicht für einfallendes Licht genutzt wird. Solche Absorberschichten können beispielsweise CdTe oder CIS/CIGS - Verbindungen bzw. den Chalkopyriten zugeordnete I-III-VI-Halbleiter umfassen.

Die an diese halbleitenden Schichten angrenzenden Schichten sind elektrisch leitend ausgebildet. Der Rückseitenkontakt ist in der Regel ein metallischer Leiter wie z.B. Molybdän, der lichtundurchlässig ist. Die an die zweite Halbleiterschicht angrenzende Schicht hingegen ist als lichtdurchlässiger elektrischer Leiter, beispielsweise aus ZnO:Al gefertigt.

Dünnschichtsolarzellen, die ein bandartiges flexibles Flächengebilde als Substrat umfassen, können in effizienten Durchlaufverfahren von Rolle zu Rolle gefertigt werden. In mehreren Prozessschritten werden auf dem Substrat mehrere Schichten aufgebaut und - wo dies erforderlich ist - zusätzlich strukturiert. Zum Aufbringen und/oder Strukturieren der Schichten können unterschiedliche, an sich bekannte Techniken angewendet werden. Insbesondere können die Halbleiterschichten z.B. besonders effizient in einem Druckverfahren aufgebracht werden. Ausgehend von einem Substrat mit elektrisch isolierender Oberfläche wird auf dieser Oberfläche zuerst eine dünne Metallschicht, beispielsweise Molybdän (Mo) abgeschieden, die bei der herzustellenden Dünnschichtsolarzelle als Rückseitenkontakt genutzt wird. Danach wird eine dünne Schicht eines ersten Halbleitermaterials mit pastöser Konsistenz bzw. als mit einem Bindemittel vermengtes Pulver auf diese Metallschicht aufgetragen und in einem Durchlaufofen gesintert. Dabei verdampft und/oder verbrennt das Bindemittel. Die erste Halbleiterschicht wirkt bei der herzustellenden Dünnschichtsolarzelle als Absorberschicht. In analoger Weise kann auch eine zweite Halbleiterschicht auf die erste Halbleiterschicht aufgetragen und gesintert werden. Alternativ kann die zweite Halbleiterschicht auch in anderer Weise, beispielsweise nasschemisch auf die erste Halbleiterschicht aufgetragen werden. Die Dicke der so hergestellten Halbleiterschichten ist insgesamt vorzugsweise kleiner als etwa 10µm, wobei die zweite Halbleiterschicht gegenüber der Absorberschicht etwa um eine bis zwei Grössenordnungen dünner ist. Anschliessend wird der transparente Frontseitenkontakt auf der oberen Halbleiterschicht abgeschieden. Diese wird dann noch von einer oder mehreren transparenten Schutzschichten überdeckt. Die zur Ausbildung mehrerer monolithisch auf einem gemeinsamen Substrat ausgebildeten, seriell und/oder parallel miteinander verschalteten Zellen erforderlichen Strukturierungsschritte werden nachfolgend kurz erläutert. Nach dem Abscheiden der ersten Metallschicht (Rückseitenkontakt) auf der elektrisch isolierenden Oberfläche des Substrats wird diese Metallschicht z.B. mittels eines Laserstrahls in mehrere elektrisch voneinander getrennte Zellen aufgeteilt. Nach dem Aufbringen und Sintern der beiden Halbleiterschichten auf diese strukturierte Metallschicht werden die Halbleiterschichten jeweils parallel zu den ersten Trennlinien im Bereich der jeweils benachbarten Zellen durchtrennt. Die darunter liegende Metallschicht (Rückseitenkontakte der jeweils benachbarten Zellen) bleibt dabei unversehrt. Danach wird die zweite elektrisch leitende Schicht auf die obere der beiden Halbleiterschichten aufgebracht. Sie ist transparent und bildet den Frontseitenkontakt. An jenen Stellen, wo die Halbleiterschichten durchtrennt sind, ist die zweite elektrisch leitende Schicht mit dem Rückseitenkontakt der jeweils benachbarten Zelle verbunden.

In einem weiteren Strukturierungsschritt werden die zweite elektrisch leitende Schicht sowie die darunterliegende zweite Halbleiterschicht mit einem geringen Versatz zu den Trennlinien des vorherigen Strukturierungsschrittes durchtrennt. In der Regel werden mehrere in dieser Weise seriell miteinander verbundene Zellen über sogenannte Busbars parallel miteinander verbunden.

Beim Sintern der Halbleiterschichten können diese insbesondere an ihren Oberflächen oxidieren. Solche Oxide an der Grenze zwischen der ersten Halbleiterschicht und der zweiten Halbleiterschicht sind Fremdstoffe bzw. Fremdphasen, die den Wirkungsgrad der zu fertigenden Solarzelle erheblich beeinträchtigen können.

Eine Aufgabe der vorliegenden Erfindung ist es deshalb, ein Verfahren zur Herstellung von Dünnschichtsolarzellen mit gesinterten Halbleiterschichten zu schaffen, bei dem der Anteil von Fremdphasen an der Grenze zwischen den Halbleiterschichten minimiert wird. Eine weitere Aufgabe der Erfindung besteht darin, eine gemäss diesem Verfahren hergestellte Dünnschichtsolarzelle mit maximiertem Wirkungsgrad zu schaffen.

Diese Aufgaben werden gelöst durch ein Verfahren gemäss den Merkmalen des Patentanspruchs 1 und durch eine Dünnschichtsolarzelle gemäss den Merkmalen des Patentanspruchs 10.

Bei der Herstellung von Dünnschichtsolarzellen können die aneinander angrenzenden Halbleiterschichten sowohl bei Substratkonfigurationen als auch bei Superstratkonfigurationen in pastöser Konsistenz aufgetragen und gesintert werden. Das erfindungsgemässe Verfahren kann bei beiden Varianten angewendet werden, wird aber im Folgenden nur für den Fall einer Substratkonfiguration beschrieben. Als Substrate können grundsätzlich beliebige thermisch beständige Flächengebilde verwendet werden, die zumindest im Bereich ihrer Oberfläche elektrisch isolierend sind. Insbesondere können dünne, flexible Substrate wie beispielsweise Polyimid oder alternativ Folien aus Metallen wie z.B. Edelstahl oder Titan verwendet werden. Bei elektrisch leitenden Metallen muss die Oberfläche jeweils mit einer dünnen elektrisch isolierenden Schicht überzogen sein.

Bei der Herstellung derartiger Dünnschichtsolarzellen werden typischerweise folgende Prozessschritte nacheinander durchgeführt:
a) auf einem als Flächengebilde mit einer elektrisch isolierenden Oberfläche ausgebildeten Substrat wird eine erste elektrisch leitende Schicht abgeschieden
b) Optional, falls mehrere monolithisch verschaltete Zellen ausgebildet werden sollen, wird diese elektrisch leitende Schicht in mehrere Zellen unterteilt,
c) auf der ersten elektrisch leitenden Schicht wird eine Schicht mit einem ersten Halbleitermaterial aufgebracht und gesintert,
d) auf dieser ersten Halbleiterschicht wird eine Schicht mit einem zweiten Halbleitermaterial aufgebracht und bei Bedarf bzw. in Abhängigkeit des jeweils eingesetzten Aufbringungsverfahrens ebenfalls gesintert,
e) Optional (bei mehreren Zellen) werden die Halbleiterschichten durch Einschnitte, die bis zur angrenzenden Metallschicht reichen, in Zellen aufgeteilt,
f) auf die freie Oberfläche, d.h. die Oberfläche der zweiten Halbleiterschicht und gegebenenfalls die freigelegten Bereiche der ersten elektrisch leitenden Schicht sowie die dazwischenliegenden Übergangsbereiche, wird eine zweite elektrisch leitende Schicht aufgebracht.

Erfindungsgemäss wird der Anteil an Fremdstoffen bzw. Fremdphasen in Form von Oxiden an der Oberfläche der ersten Halbleiterschicht auf ein Minimum reduziert, indem solche Oxide vor dem Aufbringen der zweiten Halbleiterschicht in einem separaten Behandlungsschritt von der Oberfläche der ersten Halbleiterschicht abgelöst werden und/oder indem die Bildung von Oxiden an der Oberfläche der ersten Halbleiterschicht während des Sinterns gehindert oder verhindert wird.

Die Verhinderung oder Behinderung der Ausbildung von Oxiden an der Oberfläche der ersten Halbleiterschicht kann dadurch erreicht werden, dass die Sinterung dieser ersten Halbleiterschicht unter Ausschluss von Sauerstoff in einer Schutzgasatmosphäre, beispielsweise unter Verwendung von Stickstoff als Schutzgas erfolgt.

Zum Entfernen von Oxiden von der Oberfläche der ersten Halbleiterschicht wird das Flächengebilde nach der Sinterung dieser ersten Halbleiterschicht mit einer Reinigungslösung behandelt, welche einen Komplexbildner umfasst. Vorzugsweise wird als Komplexbildner EDTA (Ethylendiamintetraacetat) verwendet. Dieses wird zusammen mit NH4OH (Ammoniumhydroxid) in einer wässrigen Lösung mit der Oberfläche der ersten Halbleiterschicht in Kontakt gebracht. Die Konzentration von EDTA und NH40H kann z.B. in einem Bereich von 0.1 bis 1 mol liegen. Der pH-Wert der Reinigungslösung liegt zwischen neutral und leicht basisch, also etwa zwischen 7 und 8.5. Die Behandlung wird vorzugsweise durch Eintauchen des beschichteten Flächengebildes in ein Bad mit der Reinigungslösung durchgeführt. Dabei lösen die EDTA und das NH3 Oxide an der Oberfläche der ersten Halbleiterschicht heraus und bilden mit diesen Oxiden Komplexe. Umfasst die erste Halbleiterschicht beispielsweise CdTe (Cadmiumtellurid), so können Oxide wie CdO und Te02 herausgelöst und gebunden werden. Kommt die Reinigungslösung mit der ersten Metallschicht, beispielsweise Mo (Molybdän) in Kontakt, so werden auch die Oxide dieses Metalls (z.B. MoO3) von der Reinigungslösung herausgelöst und gebunden.

Alternativ kann die Oberfläche der ersten Halbleiterschicht nach dem Sintern auch mit Natriumhydroxid (NaOH) 5-50% in Wasser, vorzugsweise etwa 30%, behandelt werden. Die Temperatur liegt vorzugsweise im Bereich von 15°C bis 50°C. Die Behandlung erfolgt während einer Dauer von 10 bis 300 Sekunden, vorzugsweise während etwa 60 Sekunden.

Nach der Behandlung mit der Reinigungslösung wird die Oberfläche der gereinigten ersten Halbleiterschicht mit deionisiertem Wasser (DI-Wasser) gründlich gespült. Vorzugsweise wird das Flächengebilde unmittelbar nach diesem Reinigungsschritt dem nächsten Prozessschritt - also dem Aufbringen der zweiten Halbleiterschicht - zugeführt. Eine Trocknung ist nicht zwingend erforderlich, da die zweite Halbleiterschicht in einem nasschemischen Verfahren aufgebracht wird.

Nach dem Aufbringen der zweiten Halbleiterschicht und einer anschliessenden thermischen Behandlung kann diese zweite Halbleiterschicht optional analog zur ersten Halbleiterschicht ebenfalls gereinigt werden.

Alternativ kann das Flächengebilde auch vorzugsweise in einer sauerstoffarmen Schutzatmosphäre getrocknet und zwischengelagert oder mit einer wieder ablösbaren Schutzschicht überzogen und später weiterverarbeitet werden.

Im Gegensatz zum Ätzen hat das erfindungsgemässe Reinigungsverfahren den Vorteil, dass nur unerwünschte Fremdphasen herausgelöst werden, und dass die gewünschte Stöchiometrie an der Oberfläche der Halbleiterschicht erhalten bleibt. Beim Ätzen würden unterschiedliche Ätzraten die Stöchiometrie verändern. So würde beispielsweise bei einer Halbleiterschicht aus CdTe eine Anreicherung von Te oder Cd an deren Oberfläche erfolgen. Dies ist selbstverständlich nicht tolerabel.

## Patentansprüche

1. Verfahren zur Herstellung von Dünnschichtsolarzellen, wobei
a) auf einem Flächengebilde mit einer elektrisch isolierenden Oberfläche eine erste elektrisch leitende Schicht ausgebildet wird,
b) auf dieser ersten elektrisch leitenden Schicht eine Schicht mit einem ersten Halbleitermaterial aufgebracht und gesintert wird,
c) auf dieser ersten Halbleiterschicht eine Schicht mit einem zweiten Halbleitermaterial aufgebracht wird und
d) auf dieser zweiten Halbleiterschicht eine zweite elektrisch leitende Schicht aufgebracht wird, **dadurch gekennzeichnet, dass**
der Anteil von Fremdphasen an der Oberfläche der ersten Halbleiterschicht minimiert wird, indem die Sinterung dieser ersten Halbleiterschicht in einer Schutzatmosphäre unter Ausschluss von Sauerstoff erfolgt, und/oder indem nach dem Sintern der ersten Halbleiterschicht eine Behandlung zur Entfernung von Fremdphasen an der Oberfläche dieser Halbleiterschicht durchgeführt wird.

2. Verfahren nach Anspruch 1, **dadurch gekennzeichnet, dass** das beschichtete Flächengebilde nach dem Sintern der ersten Halbleiterschicht in eine Reinigungslösung, die als Komplexiermittel für Metallionen wirkt, eingetaucht oder in anderer Weise mit einer solchen Reinigungslösung behandelt wird.

3. Verfahren nach Anspruch 2, **dadurch gekennzeichnet, dass** die Reinigungslösung als Komplexbildner Ethylendiamintetraacetat EDTA umfasst.

4. Verfahren nach Anspruch 3, **dadurch gekennzeichnet, dass** die Reinigungslösung zusätzlich Ammoniumhydroxid NH40H beinhaltet, und dass der pH-Wert der Reinigungslösung zwischen 7 und 8.5 liegt.

5. Verfahren nach einem der Ansprüche 2 bis 4, **dadurch gekennzeichnet, dass** das Komplexiermittel Oxide aus der ersten Halbleiterschicht herauslöst und mit diesen zusammen lösliche Komplexe bildet.

6. Verfahren nach Anspruch 1, **dadurch gekennzeichnet, dass** das beschichtete Flächengebilde nach dem Sintern der ersten Halbleiterschicht oder nach dem Sintern der ersten Halbleiterschicht und zusätzlich nach dem Aufbringen und thermischen Nachbehandeln der zweiten Halbleiterschicht mit Natriumhydroxid (NaOH) 5-50% in Wasser behandelt wird.

7. Verfahren nach einem der Ansprüche 1 bis 6, **dadurch gekennzeichnet, dass** die erste elektrisch leitende Schicht Molybdän oder eine Molybdänlegierung umfasst, dass die erste Halbleiterschicht Cadmiumtellurid CdTe umfasst, und dass die Fremdphasen Cadmiumoxid CdO und/oder Telluroxid TeO2 umfassen.

8. Verfahren nach einem der Ansprüche 2 bis 7, **dadurch gekennzeichnet, dass** das beschichtete Flächengebilde nach der Behandlung mit der Reinigungslösung mit deionisiertem Wasser gewaschen wird.

9. Verfahren nach Anspruch 8, **dadurch gekennzeichnet, dass** die zweite Halbleiterschicht auf die von Fremdphasen weitgehend befreite und gewaschene Oberfläche der ersten Halbleiterschicht aufgebracht wird.

10. Dünnschichtsolarzelle, umfassend der Reihe nach
a) ein Flächengebilde mit einer elektrisch isolierenden Oberfläche,
b) eine erste elektrisch leitende Schicht,
c) eine gesinterte erste Halbleiterschicht
d) eine zweite Halbleiterschicht und
e) eine zweite elektrisch leitende Schicht, **dadurch gekennzeichnet, dass** die Oberfläche der gesinterten ersten Halbleiterschicht mit einem Verfahren nach einem der Ansprüche 1 bis 9 hergestellt ist, derart, dass der Anteil von Fremdphasen an der Oberfläche der ersten Halbleiterschicht im Vergleich zu einer Herstellung dieser Halbleiterschicht ohne die kennzeichnenden Merkmale des Anspruchs 1 minimal ist.
